# EUROPEAN PATENT SPECIFICATION

(11) **EP 3 955 317 B1**
(45) Date of publication and mention of the grant of the patent: **25.11.2026**
(21) Application number: 21791243.5
(22) Date of filing: 28.01.2021
(51) Int. Cl.: H10D 30/01, H10D 30/47, H10D 30/80, H10D 62/10, H10D 62/17, H10D 62/53, H10D 64/23, H10D 62/85

(54) **NORMALLY-OFF DEVICE AND MANUFACTURING METHOD THEREFOR**
NORMALERWEISE GESCHLOSSENE VORRICHTUNG UND DEREN HERSTELLUNGSVERFAHREN
DISPOSITIF NORMALEMENT À L'ARRÊT ET SON PROCÉDÉ DE FABRICATION

(30) Priority: 24.06.2020 CN 202010590696
(43) Date of publication of application: 16.02.2022
(73) Proprietor: Guangdong Zhineng Technology Co., Ltd., Guangzhou, Guangdong 510700 (CN)
(72) Inventor: LI, Zilan, Guangzhou Guangdong 510700 (CN)
(74) Representative: Loyer & Abello
(86) International application number: PCT/CN2021/074156
(87) International publication number: WO 2021/258732

(56) References cited:
- WO-A1-2020/055984
- CN-U- 210 467 852
- CN-U- 212 062 440
- CN-U- 212 062 440
- US-A1- 2012 267 637
- US-A1- 2013 256 685
- US-A1- 2020 013 862
- US-A1- 2022 093 779

## Description

### Technical Field

The present disclosure relates to the technical field of semiconductors, in particular, to a normally-closed device and a fabrication method thereof.

### Background Art

Currently, the process of fabricating a normally-closed device is generally realized by fabricating a P-type nitride semiconductor gate electrode on a barrier layer. Due to the poor insulation performance of the barrier layer, the occurrence of a large gate current is easily caused. Meanwhile, due to the separation of the barrier layer, the gate electrode is also relatively far from a channel, which is not favorable for obtaining a relatively high threshold voltage.

In summary, there is a problem in the prior art that the normally-closed device has relatively low threshold voltage and relatively large gate current and drain current.

WO2020055984A1 discloses a gallium nitride enhancement mode device. The device is a HEMT comprising a buried p-type layer disposed under the channel layer and which is partly modified by deactivating by ion implantation said p-type layer in a region outside of the gate electrode region. The part of the p-type layer located in the gate electrode region is connected to a control electrode via a non modified portion of the p-type layer.

The document US2013256685A1 discloses a compound semiconductor device and method for manufacturing the same.

### Summary

The present disclosure provides a normally-closed device and a fabrication method thereof, so as to solve the problems in the prior art that the normally-closed device has relatively low threshold voltage and relatively large gate current and drain current In one aspect, the present invention provides a normally-closed device as defined in claim 1. In another aspect, the present invention provides a fabrication method of a normally-closed device as defined in claim 7. Advantageous embodiments are set out in the dependent claims.

Compared with the prior art, beneficial effects of the present disclosure, for example, include that, as it is easier to realize the manner of performing modification in some regions, it can be more conveniently realized that an effective P-type and desired device structure only exist in some regions.

### Brief Description of Drawings

In order to more clearly illustrate technical solutions of embodiments of the present disclosure, accompanying drawings which need to be used in the embodiments will be introduced briefly below, and it should be understood that the accompanying drawings below merely show some embodiments of the present disclosure, therefore, they should not be considered as limitation on the scope, and those ordinarily skilled in the art still could obtain other relevant drawings according to these accompanying drawings, without using any creative efforts.
FIG. 1 is a sectional diagram of a normally-closed device provided in an embodiment that does not form part of the claimed invention.
FIG. 2 is a flow chart of a fabrication method of a normally-closed device provided in an embodiment that does not form part of the claimed invention.
FIG. 3 is a flow chart of sub-steps of S106 in FIG. 2 provided in an embodiment that does not form part of the claimed invention.
FIG. 4 is a sectional diagram of another normally-closed device provided in an embodiment of the present invention.
FIG. 5 is a flow chart of a fabrication method of another normally-closed device provided in an embodiment of the present invention.
FIG. 6 is a flow chart of sub-steps of S206 in FIG. 5 provided in an embodiment of the present invention.

In the drawings: 100-normally-closed device; 110-substrate; 120-buffer layer; 130-first P-type nitride layer; 140-modified layer; 150-channel layer; 160-barrier layer; 170-passivation layer; 180-body electrode.

### Detailed Description of Embodiments

In order to make objectives, technical solutions, and advantages of the embodiments of the present disclosure clearer, the technical solutions in the embodiments of the present disclosure will be described clearly and completely below in conjunction with accompanying drawings in the embodiments of the present disclosure, and apparently, the embodiments described are some but not all embodiments of the present disclosure. Generally, components in the embodiments of the present disclosure, as described and shown in the accompanying drawings herein, may be arranged and designed in various different configurations.

Therefore, the detailed description below of the embodiments of the present disclosure provided in the accompanying drawings is not intended to limit the scope of the present disclosure claimed, but merely illustrates chosen embodiments of the present disclosure. All of other embodiments obtained by those ordinarily skilled in the art based on the embodiments in the present disclosure without using creative efforts shall fall within the scope of protection of the present disclosure.

It should be noted that similar reference signs and letters represent similar items in the following accompanying drawings, therefore, once a certain item is defined in one accompanying drawing, it is not needed to be further defined or explained in subsequent accompanying drawings. Meanwhile, in the description of the present disclosure, terms such as "first" and "second" are merely for distinctive description, but should not be construed as indicating or implying importance in relativity.

It should be indicated that in the present text, relational terms such as first and second are merely for distinguishing one entity or operation from another entity or operation, while it is not necessarily required or implied that these entities or operations have any such practical relation or order. Moreover, terms "including", "containing" or any other variations thereof are intended to be nonexclusive, thus a process, method, article or device including a series of elements not only include those elements, but also include other elements that are not listed definitely, or further include elements inherent to such process, method, article or device. Without more restrictions, an element defined with wordings "including a..." does not exclude presence of other same elements in the process, method, article or device including said element.

In the description of the present disclosure, it should be indicated that orientation or positional relationships indicated by terms such as "upper", "lower", "inner", and "outer" are based on orientation or positional relationships as shown in the drawings, or orientation or positional relationships of a product of the present disclosure when being conventionally placed in use, merely for facilitating describing the present disclosure and simplifying the description, rather than indicating or suggesting that related devices or elements have to be in the specific orientation or configured and operated in a specific orientation, therefore, they should not be construed as limiting the present disclosure.

In the description of the present disclosure, it should be further illustrated that, unless otherwise specifically regulated and defined, the terms "set" and "connect" should be understood in a broad sense, for example, connection may be fixed connection, detachable connection, or integrated connection; it may be mechanical connection or electrical connection; it may be direct joining or indirect joining through an intermediary, and it also may be inner communication between two elements. For those ordinarily skilled in the art, specific meanings of the above-mentioned terms in the present disclosure could be understood according to specific circumstances.

Some embodiments of the present disclosure are described in detail below in combination with the accompanying drawings. The following embodiments and features in the embodiments may be combined with each other without conflict.

As described in the Background Art, currently, the process of fabricating a normally-closed device is generally realized by fabricating a P-type nitride semiconductor gate electrode on a barrier layer. Due to the poor insulation performance of the barrier layer, the occurrence of a large gate current is easily caused. Meanwhile, due to the separation of the barrier layer, the gate electrode is also relatively far from a channel, which is not favorable for obtaining a high threshold voltage.

In view of this, the present disclosure provides a normally-closed device, which makes the process able to be easily implemented by modifying a P-type nitride layer in some regions into a modified layer, and meanwhile increases a threshold voltage of the normally-closed device and decreases gate and drain currents of the normally-closed device.

Hereinafter, the normally-closed device provided in the present disclosure is exemplarily described.

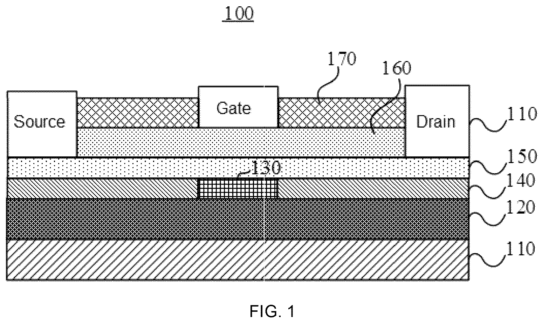

Referring to FIG. 1, as an optional implementation, a normally-closed device 100 includes a substrate 110, an epitaxial layer, a barrier layer 160, and an electrode. In the above, the epitaxial layer includes a first P-type nitride layer 130 and a modified layer 140, and the modified layer 140 is located on two sides of the first P-type nitride layer 130. In the above, the modified layer 140 provided in the present disclosure is formed by modifying a second P-type nitride layer in a preset region, and the first P-type nitride layer 130 and the second P-type nitride layer are formed by epitaxially growing synchronously.

In the above, the present disclosure does not define the material of the substrate 110, for example, the substrate 110 may be a sapphire substrate 110, a silicon substrate 110, or the like.

The epitaxial layer in the present disclosure includes a buffer layer 120, a first P-type nitride layer 130, and a modified layer 140. In a fabrication process, first, the buffer layer 120 is grown along a growth surface of the substrate 110, and then the P-type nitride layer is grown on a surface of the buffer layer 120.

In the above, the buffer layer 120 in the present disclosure may be a GaN buffer layer 120, the P-type nitride layer may be a P-type GaN layer, and certainly, in some other embodiments, other materials also may be possible, for example, a P-type AlGaN layer. Moreover, for convenience of description, the P-type nitride layer provided in the present disclosure may be divided into a first P-type nitride layer 130 and a second P-type nitride layer, wherein the first P-type nitride layer 130 is located in a gate electrode region, the second P-type nitride layer is located in a source electrode region, a region between a gate electrode and a source electrode, a drain electrode region, and a region between the gate electrode and a drain electrode, furthermore, the second P-type nitride layer is located on two sides of the first P-type nitride layer 130.

It may be understood that the first P-type nitride layer 130 and the second P-type nitride layer are actually grown simultaneously, therefore, they have the same doping concentration. Moreover, as an implementation, the first P-type nitride layer 130 and the second P-type nitride layer also have the same height.

Meanwhile, the modification in the present disclosure refers to changing the activity of the second P-type nitride layer, that is, changing the active P-type GaN to be of an N-type or to be in a high resistance state or an insulating type. As an implementation, the property of the second P-type nitride layer may be changed in a manner of ion implantation, for example, N-type impurities such as Si and Ge may be implanted, or the P-type GaN may also be changed to be in a high resistance or insulating state by ion implantation, and optional implanted impurities include N, Ar, and the like.

It may be understood that, when the barrier layer 160 is continuously grown on the basis of the above structure, the P-type layer in contact with the barrier layer 160 is only the first P-type nitride layer 130. Then, the gate electrode is fabricated on the barrier layer 160, and meanwhile the barrier layer 160 on the two sides is etched until the modified layer 140 on two sides is exposed, and then the source electrode and the drain electrode are respectively fabricated. In the above, a material of the barrier layer 160 provided in the present disclosure may be AlGaN, AlInN or AlInGaN.

It should be noted that, the P-type nitride layer will not deplete twodimensional electron gas in the modified region, thus maintaining a good transport property. Meanwhile, in the art, as the first P-type nitride layer 130 is formed in a manner of ion implantation, a crystal structure is easily damaged. But in the present disclosure, the first P-type nitride layer 130 is realized by a material growth method, which does not easily cause damage to the crystal structure. Moreover, it is easier to modify the P-type nitride layer in some regions to an N-type or an insulating type by a method of performing doping by ion implantation of N-type impurities, so that it is possible to realize that an effective P-type and a desired device structure only exist in some regions.

Meanwhile, by means of the above arrangement, on the one hand, the twodimensional electron gas will not be depleted partially or completely, therefore on-resistance of the device will not be increased, and on the other hand, the first P-type nitride layer 130 can also be far away from the drain electrode, so that a breakdown voltage of the device is higher.

As an optional implementation, in order to reduce scattering effect and other effects of the first P-type nitride layer 130 or implanted impurities, and improve mobility of channel electrons, the normally-closed device 100 provided in the present disclosure further includes a channel layer 150, wherein one side of the channel layer 150 is connected to the first P-type nitride and the modified layer 140 respectively, and the other side of the channel layer 150 is connected to the barrier layer 160, the source electrode, and the drain electrode. As the gate electrode provided in the present disclosure will not be relatively far from the channel due to the spacing/separation of the barrier layer, it is more advantageous to obtain a higher threshold voltage.

Moreover, in order to make the device more stable, a passivation layer 170 generally also needs to be formed on the barrier layer 160. In order to decrease the gate and drain currents, an insulating layer located between the gate electrode and the barrier layer 160 further may be formed.

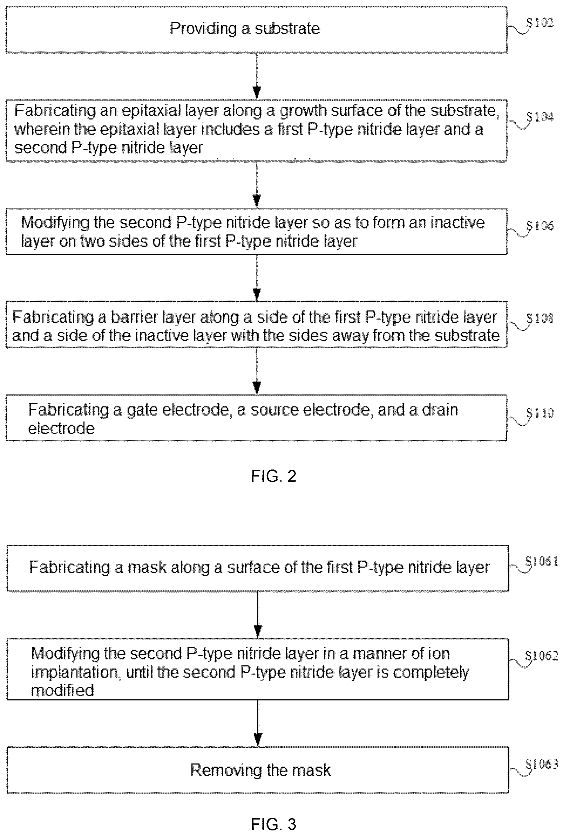

The present disclosure further provides a fabrication method of a normally-closed device. Referring to FIG. 2, the method includes:
S102, providing a substrate;
S104, fabricating an epitaxial layer along a growth surface of the substrate, wherein the epitaxial layer includes a first P-type nitride layer and a second P-type nitride layer, the second P-type nitride layer is located on two sides of the first P-type nitride layer, and the first P-type nitride layer and the second P-type nitride layer are located on a same plane;
S106, modifying the second P-type nitride layer so as to form a modified layer on two sides of the first P-type nitride layer;
S108, fabricating a barrier layer along a side of the first P-type nitride layer and a side of the modified layer, with the sides away from the substrate; and
S110, fabricating a gate electrode, a source electrode, and a drain electrode.

In the above, referring to FIG. 3, S106 includes:
S1061, fabricating a mask along a surface of the first P-type nitride layer;
S1062, modifying the second P-type nitride layer in a manner of ion implantation, until the second P-type nitride layer is completely modified; and
S1063, removing the mask.

Certainly, in order to reduce the ion implantation damage, heat treatment or the like also may be performed after removing the mask.

Moreover, S1062 actually may be a step of implanting Si, Ge, N or Ar into the second P-type nitride layer in a manner of ion implantation, wherein when N-type impurities such as Si and Ge are implanted, the second P-type nitride layer may be modified to be of N-type, and when impurities such as N and Ar are implanted, the second P-type nitride layer may be modified to be in a high resistance state or an insulating state.

Optionally, a channel layer also may be epitaxially grown first before the barrier layer is formed, to further reduce scattering effect and other effects caused by the first P-type nitride layer or implanted impurities, and improve the mobility of the electrons in the channel. Meanwhile, in order to make the device more stable, a passivation layer generally further needs to be formed on the barrier layer. In order to decrease the gate current and the drain current, an insulating layer further may be formed between the gate electrode and the barrier layer.

In the above embodiment, as only the first P-type nitride layer 130 exists and the first P-type nitride layer 130 in this region is not connected to an external electrode, the threshold voltage of the device may be caused unstable.

In view of this, in order to make the threshold voltage of the device more stable, an embodiment of the present disclosure further provides another normally-closed device 100. As the normally-closed device 100 provided in the present embodiment is merely partially different from the normally-closed device 100 provided in the preceding embodiment in structure, only differences between the two are described in the present embodiment, while reference is made to the preceding embodiment for similarities.

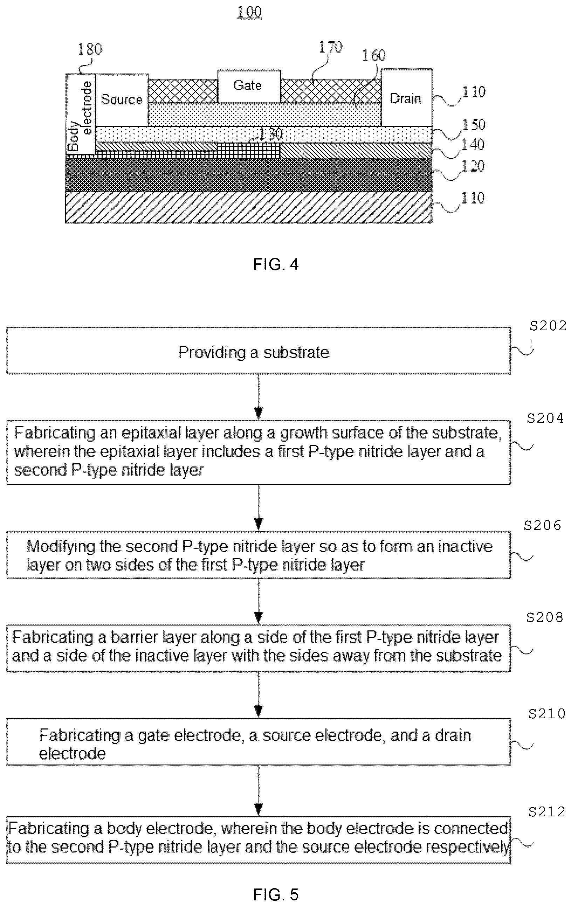

Referring to FIG. 4, as an implementation, the modified layer 140 located in the drain electrode region and a region between the gate electrode and the drain electrode has the same height as the first P-type nitride layer 130, the height of the modified layer 140 located in the source electrode region and a region between the gate electrode and the source electrode is less than that of the first P-type nitride layer 130, and the modified layer 140 located in the source electrode region and the region between the gate electrode and the source electrode is formed by partially modifying the second P-type nitride layer, so that the modified layer 140 is connected to the second P-type nitride layer and the barrier layer 160, respectively. Moreover, the normally-closed device 100 further includes a body electrode 180, and the body electrode 180 is connected to the second P-type nitride layer and the source electrode, respectively.

The present embodiment retains a part of the second P-type nitride layer in the source electrode region and the region between the gate electrode and the source electrode, and only an upper portion of the second P-type nitride layer is modified, thus, through a lower portion of the second P-type nitride layer, the second P-type nitride layer is electrically connected to the first P-type nitride layer 130 and the potential of the second P-type nitride layer is controlled. In a practical fabrication process, the mask may be fabricated first in the gate electrode region, and then the second P-type nitride layer on two sides is modified. It should be noted that energy and dose of the ion implantation this time are relatively low, therefore only the property of an upper layer is changed, while the lower second P-type nitride layer is still an active layer.

Then, the mask is removed, and meanwhile a new mask is fabricated, so as to cover the gate electrode region, the region between the gate electrode and the source electrode, and the source electrode region, and ions are implanted at high energy and high dose into the drain electrode region and the region between the gate electrode and the drain electrode, so that the second P-type nitride layer in the drain electrode region and the region between the gate electrode and the drain electrode is completely modified to be of an N-type or an insulating type. Finally, the mask is removed.

Meanwhile, after the electrode has been fabricated, the source electrode region further may be etched, so as to form a mounting region, wherein the mounting region penetrates through the barrier layer 160 and the modified layer 140 located in the source electrode region, and the body electrode 180 is provided in the mounting region.

Certainly, in some other embodiments not falling within the scope of the claimed invention, the second P-type nitride layer in the drain electrode region and the region between the gate electrode and the drain electrode may also be treated similarly. That is, the second P-type nitride layer in the drain electrode region and the region between the gate electrode and the drain electrode is partially modified, so that the modified layer located in the drain electrode region and the region between the gate electrode and the drain electrode is connected to the second P-type nitride layer and the barrier layer 160, respectively.

Moreover, it should be noted that in order to make the modification effect and the contact effect with the body electrode better, the doping concentration of the second P-type nitride layer provided in the present disclosure is variable in the epitaxial growth direction. For example, as an optional implementation, the doping concentration of the second P-type nitride layer is decreased in the epitaxial growth direction, that is, in the second P-type nitride layer, the doping concentration of a side close to the buffer layer is relatively high, and the doping concentration of a side away from the buffer layer is relatively low, then on this basis, the mounting region may be directly extended to the high concentration region, so that good ohmic contact is formed between the body electrode and the second P-type nitride layer. In another implementation of the present disclosure, the doping concentration of the second P-type nitride layer is decreased first and then increased in the epitaxial growth direction. That is, the second P-type nitride layer has a relatively high doping concentration on the side thereof close to the buffer layer, a relatively low doping concentration in an intermediate region thereof, and also a relatively high doping concentration on the side thereof away from the buffer layer. In this arrangement manner, the mounting region may be extended to the high concentration region close to the buffer layer when the mounting region is fabricated, so as to form a good ohmic contact between the body electrode and the second P-type nitride layer. Meanwhile, as a high concentration doping mode is adopted when modifying the upper portion of the second P-type nitride layer, the unmodified P-type nitride region below the gate electrode has a relatively high doping concentration, so that a relatively high threshold voltage may be obtained.

An embodiment of the present disclosure further provides a fabrication method of another normally-closed device, and referring to FIG. 5, the method includes:
S202, providing a substrate;
S204, fabricating an epitaxial layer in a growth surface of the substrate, wherein the epitaxial layer includes a first P-type nitride layer and a second P-type nitride layer, the second P-type nitride layer is located on two sides of the first P-type nitride layer, and the first P-type nitride layer and the second P-type nitride layer are formed by epitaxially growing synchronously;
S206, modifying the second P-type nitride layer so as to form a modified layer on two sides of the first P-type nitride layer;
S208, fabricating a barrier layer along a side of the first P-type nitride layer and a side of the modified layer, with the sides away from the substrate;
S210, fabricating a gate electrode, a source electrode, and a drain electrode; and
S212, fabricating a body electrode, wherein the body electrode is connected to the second P-type nitride layer and the source electrode, respectively.

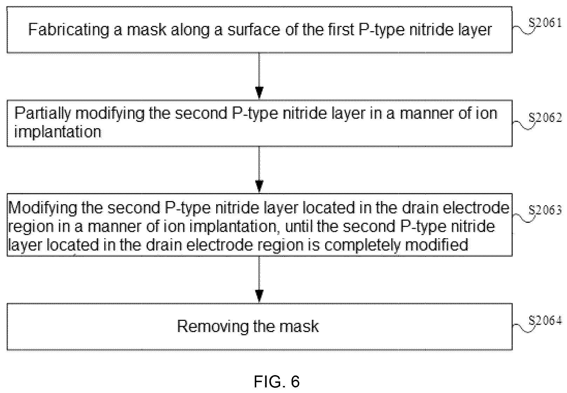

In the above, referring to FIG. 6, S206 includes:
S2061, fabricating a mask along a surface of the first P-type nitride layer;
S2062, partially modifying the second P-type nitride layer in a manner of ion implantation;
S2063, modifying the second P-type nitride layer located in the drain electrode region in a manner of ion implantation, until the second P-type nitride layer located in the drain electrode region is completely modified; and
S2064, removing the mask.

In the above, in S2062, ions may be implanted into the second P-type nitride layer according to first energy and dose.

In S2063, ions may be implanted into the second P-type nitride layer according to second energy and dose, wherein the first energy and dose are less than the second energy and dose.

The above-mentioned are merely preferred embodiments of the present disclosure and not used to limit the present disclosure. For one skilled in the art, various modifications and changes may be made to the present disclosure.

For one skilled in the art, obviously, the present disclosure is not limited to details of the above exemplary embodiments. Therefore, no matter from which point of view, the embodiments should be regarded as exemplary but non-limiting, the scope of the present disclosure is defined by the appended claims rather than the above description, therefore all changes falling within the meaning and scope of the claims are intended to be covered within the present disclosure. Any reference signs in the claims should not be regarded as limiting the claims involved.

### Industrial Applicability

The present disclosure provide a normally-closed device and a fabrication method thereof, which solve the problems existing in the prior art that the normally-closed device has relatively low threshold voltage and relative high gate and drain currents, and as it is easier to realize the manner of performing modification in some regions, it can be more conveniently realized that an effective P-type and desired device structure only exist in some regions.

## Claims

1. A normally-closed HEMT device (100), wherein the normally-closed device (100) comprises:
a substrate (110);
an epitaxial layer connected to the substrate (110), wherein the epitaxial layer comprises a first P-type nitride layer (130), a second P-type nitride layer (140) and a modified layer (140), the modified layer (140) is located on two sides of the first P-type nitride layer (130), the modified layer (140) is formed by modifying the second P-type nitride layer so as to render it N-type, high resistive or insulating in a preset region, and the first P-type nitride layer (130) and the second P-type nitride layer are formed by epitaxially growing synchronously;
a barrier layer (160) above the first P-type nitride layer (130) and the modified layer (140); and
a gate electrode above the barrier layer (160), wherein the gate electrode is connected to the barrier layer, and wherein the first P-type nitride layer is located in a region corresponding to the gate electrode;
a source electrode and a drain electrode; wherein the normally-closed device (100) further comprises a channel layer (150), wherein one side of the channel layer (150) is connected to the first P-type nitride layer (130) and the modified layer (140) respectively, and the other side of the channel layer (150) is connected to the barrier layer (160), the source electrode, and the drain electrode;
wherein a height of the portion of the modified layer (140) located in a source electrode region and a region between the source electrode and the gate electrode is less than a height of the first P-type nitride layer (130), and said portion of the modified layer (140) is formed by partially modifying a portion of the second P-type nitride layer, so that said portion of the modified layer (140) is connected to the part of said portion of the second P-type nitride layer which is not modified and to the channel layer (150), respectively; and
the normally-closed device (100) further comprises a body electrode (180) connected to the part of said portion of the second P-type nitride layer which is not modified;
wherein the part of said portion of the second P-type nitride layer which is not modified is electrically connected to first P-type nitride layer (130);
**characterized in that** a doping concentration of the second P-type nitride layer is variable in an epitaxial growth direction
and **in that** the body electrode is connected to the source electrode.

2. The normally-closed device (100) according to claim 1, wherein the doping concentration of the second P-type nitride layer is decreased in the epitaxial growth direction.

3. The normally-closed device (100) according to claim 1, wherein the doping concentration of the second P-type nitride layer is decreased first and then increased in the epitaxial growth direction.

4. The normally-closed device (100) according to any one of claims 1 to 3, wherein the epitaxial layer comprises a buffer layer (120), and the buffer layer (120) is grown along a growth surface of the substrate (110).

5. The normally-closed device (100) according to any one of claims 1 to 4, wherein the normally-closed device (100) comprises a mounting region, the mounting region penetrates through the barrier layer (160) and the modified layer (140) located in the source electrode region, and the body electrode (180) is provided in the mounting region.

6. The normally-closed device (100) according to any one of claims 1 to 5, wherein the normally-closed device (100) further comprises a passivation layer (170) formed on the barrier layer (160).

7. A fabrication method of a normally-closed HEMT device (100) according to claim 1, wherein the method comprises:
providing said substrate (110);
fabricating an epitaxial layer along a growth surface of the substrate (110), wherein the epitaxial layer comprises said first P-type nitride layer (130) and said second P-type nitride layer, the second P-type nitride layer is located on two sides of the first P-type nitride layer (130), the first P-type nitride layer (130) and the second P-type nitride layer are formed by epitaxially growing synchronously, and a doping concentration of the second P-type nitride layer is variable in an epitaxial growth direction;
modifying the second P-type nitride layer so as to form said modified layer (140) on two sides of the first P-type nitride layer
fabricating said channel layer (150);
fabricating said barrier layer (160); and
fabricating said gate electrode, said source electrode, and said drain electrode;
wherein the step of modifying the second P-type nitride layer so as to form a modified layer (140) on two sides of the first P-type nitride layer (130) comprises:
fabricating a mask along a surface of the first P-type nitride layer (130);
partially modifying the second P-type nitride layer by ion implantation;
modifying the second P-type nitride layer located in a drain electrode region by ion implantation, until the second P-type nitride layer located in the drain electrode region is completely modified; and
removing the mask, and
after the step of fabricating said gate electrode, said source electrode, and said drain electrode, the method further comprises:
fabricating said body electrode (180), wherein the body electrode (180) is connected to the second P-type nitride layer and the source electrode, respectively.

8. The fabrication method of a normally-closed device (100) according to claim 7, wherein the step of modifying the second P-type nitride layer by ion implantation comprises:
implanting Si, Ge, N or Ar into the second P-type nitride layer by ion implantation.

9. The fabrication method of a normally-closed device (100) according to claim 7, wherein the step of partially modifying the second P-type nitride layer by ion implantation comprises:
implanting ions into the second P-type nitride layer according to a first energy and dose, and
the step of modifying the second P-type nitride layer located in a drain electrode region by ion implantation until the second P-type nitride layer located in the drain electrode region is completely modified comprises:
implanting ions into the second P-type nitride layer according to a second energy and dose, wherein the first energy and dose are less than the second energy and dose.

## Patentansprüche

1. Normalerweise geschlossene HEMT-Vorrichtung (100), wobei die normalerweise geschlossene Vorrichtung (100) umfasst:
ein Substrat (110);
eine epitaktische Schicht, die mit dem Substrat (110) verbunden ist, wobei die epitaktische Schicht eine erste P-Typ-Nitridschicht (130), eine zweite P-Typ-Nitridschicht (140) und eine modifizierte Schicht (140) umfasst, wobei sich die modifizierte Schicht (140) auf zwei Seiten der ersten P-Typ-Nitridschicht (130) befindet, die modifizierte Schicht (140) durch Modifizieren der zweiten P-Typ-Nitridschicht gebildet ist, um sie in einem vorgegebenen Bereich vom N-Typ, hochohmig oder isolierend zu machen, und die erste P-Typ-Nitridschicht (130) und die zweite P-Typ-Nitridschicht durch synchrones epitaktisches Aufwachsen gebildet sind;
eine Barriereschicht (160) oberhalb der ersten P-Typ-Nitridschicht (130) und der modifizierten Schicht (140); und
eine Gate-Elektrode oberhalb der Barriereschicht (160), wobei die Gate-Elektrode mit der Barriereschicht verbunden ist und wobei sich die erste P-Typ-Nitridschicht in einem der Gate-Elektrode entsprechenden Bereich befindet;
eine Source-Elektrode und eine Drain-Elektrode; wobei die normalerweise geschlossene Vorrichtung (100) ferner eine Kanalschicht (150) umfasst, wobei eine Seite der Kanalschicht (150) jeweils mit der ersten P-Typ-Nitridschicht (130) und der modifizierten Schicht (140) verbunden ist, und die andere Seite der Kanalschicht (150) mit der Barriereschicht (160), der Source-Elektrode und der Drain-Elektrode verbunden ist;
wobei eine Höhe des Abschnitts der modifizierten Schicht (140), der sich in einem Source-Elektrodenbereich und einem Bereich zwischen der Source-Elektrode und der Gate-Elektrode befindet, geringer ist als eine Höhe der ersten P-Typ-Nitridschicht (130), und der Abschnitt der modifizierten Schicht (140) durch teilweises Modifizieren eines Abschnitts der zweiten P-Typ-Nitridschicht gebildet ist, sodass der Abschnitt der modifizierten Schicht (140) jeweils mit dem Teil des Abschnitts der zweiten P-Typ-Nitridschicht, der nicht modifiziert ist, und mit der Kanalschicht (150) verbunden ist; und
die normalerweise geschlossene Vorrichtung (100) umfasst ferner eine Body-Elektrode (180), die mit dem Teil des Abschnitts der zweiten P-Typ-Nitridschicht, der nicht modifiziert ist, verbunden ist;
wobei der Teil des Abschnitts der zweiten P-Typ-Nitridschicht, der nicht modifiziert ist, elektrisch mit der ersten P-Typ-Nitridschicht (130) verbunden ist;
**dadurch gekennzeichnet, dass** eine Dotierungskonzentration der zweiten P-Typ-Nitridschicht in einer epitaktischen Wachstumsrichtung variabel ist und dass die Body-Elektrode mit der Source-Elektrode verbunden ist.

2. Normalerweise geschlossene Vorrichtung (100) nach Anspruch 1, wobei die Dotierungskonzentration der zweiten P-Typ-Nitridschicht in der epitaktischen Wachstumsrichtung abnimmt.

3. Normalerweise geschlossene Vorrichtung (100) nach Anspruch 1, wobei die Dotierungskonzentration der zweiten P-Typ-Nitridschicht in der epitaktischen Wachstumsrichtung zuerst abnimmt und dann zunimmt.

4. Normalerweise geschlossene Vorrichtung (100) nach einem der Ansprüche 1 bis 3, wobei die epitaktische Schicht eine Pufferschicht (120) umfasst und die Pufferschicht (120) entlang einer Wachstumsoberfläche des Substrats (110) aufgewachsen ist.

5. Normalerweise geschlossene Vorrichtung (100) nach einem der Ansprüche 1 bis 4, wobei die normalerweise geschlossene Vorrichtung (100) einen Montagebereich umfasst, der Montagebereich die Barriereschicht (160) und die im Source-Elektrodenbereich befindliche modifizierte Schicht (140) durchdringt und die Body-Elektrode (180) in dem Montagebereich vorgesehen ist.

6. Normalerweise geschlossene Vorrichtung (100) nach einem der Ansprüche 1 bis 5, wobei die normalerweise geschlossene Vorrichtung (100) ferner eine Passivierungsschicht (170) umfasst, die auf der Barriereschicht (160) gebildet ist.

7. Herstellungsverfahren für eine normalerweise geschlossene HEMT-Vorrichtung (100) nach Anspruch 1, wobei das Verfahren umfasst:
Bereitstellen des Substrats (110);
Herstellen einer epitaktischen Schicht entlang einer Wachstumsoberfläche des Substrats (110), wobei die epitaktische Schicht die erste P-Typ-Nitridschicht (130) und die zweite P-Typ-Nitridschicht umfasst, wobei sich die zweite P-Typ-Nitridschicht auf zwei Seiten der ersten P-Typ-Nitridschicht (130) befindet, die erste P-Typ-Nitridschicht (130) und die zweite P-Typ-Nitridschicht durch synchrones epitaktisches Aufwachsen gebildet werden und eine Dotierungskonzentration der zweiten P-Typ-Nitridschicht in einer epitaktischen Wachstumsrichtung variabel ist;
Modifizieren der zweiten P-Typ-Nitridschicht, um die modifizierte Schicht (140) auf zwei Seiten der ersten P-Typ-Nitridschicht zu bilden
Herstellen der Kanalschicht (150);
Herstellen der Barriereschicht (160); und
Herstellen der Gate-Elektrode, der Source-Elektrode und der Drain-Elektrode;
wobei der Schritt des Modifizierens der zweiten P-Typ-Nitridschicht, um eine modifizierte Schicht (140) auf zwei Seiten der ersten P-Typ-Nitridschicht (130) zu bilden, umfasst:
Herstellen einer Maske entlang einer Oberfläche der ersten P-Typ-Nitridschicht (130);
teilweises Modifizieren der zweiten P-Typ-Nitridschicht durch Ionenimplantation;
Modifizieren der in einem Drain-Elektrodenbereich befindlichen zweiten P-Typ-Nitridschicht durch Ionenimplantation, bis die im Drain-Elektrodenbereich befindliche zweite P-Typ-Nitridschicht vollständig modifiziert ist; und
Entfernen der Maske, und
nach dem Schritt des Herstellens der Gate-Elektrode, der Source-Elektrode und der Drain-Elektrode umfasst das Verfahren ferner:
Herstellen der Body-Elektrode (180), wobei die Body-Elektrode (180) jeweils mit der zweiten P-Typ-Nitridschicht und der Source-Elektrode verbunden ist.

8. Herstellungsverfahren für eine normalerweise geschlossene Vorrichtung (100) nach Anspruch 7, wobei der Schritt des Modifizierens der zweiten P-Typ-Nitridschicht durch Ionenimplantation umfasst:
Implantieren von Si, Ge, N oder Ar in die zweite P-Typ-Nitridschicht durch Ionenimplantation.

9. Herstellungsverfahren für eine normalerweise geschlossene Vorrichtung (100) nach Anspruch 7, wobei der Schritt des teilweisen Modifizierens der zweiten P-Typ-Nitridschicht durch Ionenimplantation umfasst:
Implantieren von Ionen in die zweite P-Typ-Nitridschicht gemäß einer ersten Energie und Dosis, und
der Schritt des Modifizierens der in einem Drain-Elektrodenbereich befindlichen zweiten P-Typ-Nitridschicht durch Ionenimplantation, bis die im Drain-Elektrodenbereich befindliche zweite P-Typ-Nitridschicht vollständig modifiziert ist, umfasst:
Implantieren von Ionen in die zweite P-Typ-Nitridschicht gemäß einer zweiten Energie und Dosis, wobei die erste Energie und Dosis geringer sind als die zweite Energie und Dosis.

## Revendications

1. Dispositif HEMT normalement fermé (100), dans lequel le dispositif normalement fermé (100) comprend :
un substrat (110) ;
une couche épitaxiale reliée au substrat (110), dans lequel la couche épitaxiale comprend une première couche de nitrure de type P (130), une deuxième couche de nitrure de type P (140) et une couche modifiée (140), la couche modifiée (140) est située de part et d'autre de la première couche de nitrure de type P (130), la couche modifiée (140) est formée en modifiant la deuxième couche de nitrure de type P de manière à la rendre de type N, hautement résistive ou isolante dans une région prédéfinie, et la première couche de nitrure de type P (130) et la deuxième couche de nitrure de type P sont formées par croissance épitaxiale synchrone ;
une couche barrière (160) au-dessus de la première couche de nitrure de type P (130) et de la couche modifiée (140) ; et
une électrode de grille au-dessus de la couche barrière (160), dans laquelle l'électrode de grille est connectée à la couche barrière, et dans laquelle la première couche de nitrure de type P est située dans une région correspondant à l'électrode de grille ;
une électrode de source et une électrode de drain ; le dispositif normalement fermé (100) comprenant en outre une couche de canal (150), dans laquelle un côté de la couche de canal (150) est connecté respectivement à la première couche de nitrure de type P (130) et à la couche modifiée (140), et l'autre côté de la couche de canal (150) est relié à la couche barrière (160), à l'électrode de source et à l'électrode de drain ;
dans lequel une hauteur de la partie de la couche modifiée (140) située dans une région de l'électrode de source et une région entre l'électrode de source et l'électrode de grille est inférieure à la hauteur de la première couche de nitrure de type P (130), et ladite partie de la couche modifiée (140) est formée en modifiant partiellement une partie de la deuxième couche de nitrure de type P, de sorte que ladite partie de la couche modifiée (140) soit connectée respectivement à la partie de ladite partie de la deuxième couche de nitrure de type P qui n'est pas modifiée et à la couche de canal (150) ; et
le dispositif normalement fermé (100) comprend en outre une électrode de corps (180) connectée à la partie de ladite partie de la deuxième couche de nitrure de type P qui n'est pas modifiée ;
dans lequel la partie de ladite portion de la deuxième couche de nitrure de type P qui n'est pas modifiée étant reliée électriquement à la première couche de nitrure de type P (130) ;
**caractérisé en ce que** la concentration de dopage de la deuxième couche de nitrure de type P varie dans la direction de croissance épitaxiale et **en ce que** l'électrode de corps est reliée à l'électrode de source.

2. Dispositif normalement fermé (100) selon la revendication 1, dans lequel la concentration de dopage de la deuxième couche de nitrure de type P diminue dans la direction de croissance épitaxiale.

3. Dispositif normalement fermé (100) selon la revendication 1, dans lequel la concentration de dopage de la deuxième couche de nitrure de type P diminue d'abord, puis augmente dans la direction de croissance épitaxiale.

4. Dispositif normalement fermé (100) selon l'une quelconque des revendications 1 à 3, dans lequel la couche épitaxiale comprend une couche tampon (120), et la couche tampon (120) est formée le long d'une surface de croissance du substrat (110).

5. Dispositif normalement fermé (100) selon l'une quelconque des revendications 1 à 4, dans lequel le dispositif normalement fermé (100) comprend une région de montage, la région de montage traverse la couche barrière (160) et la couche modifiée (140) situées dans la région de l'électrode de source, et l'électrode de corps (180) est prévue dans la région de montage.

6. Dispositif normalement fermé (100) selon l'une quelconque des revendications 1 à 5, dans lequel le dispositif normalement fermé (100) comprend en outre une couche de passivation (170) formée sur la couche barrière (160).

7. Procédé de fabrication d'un dispositif HEMT normalement fermé (100) selon la revendication 1, dans lequel le procédé comprend les étapes consistant à :
fournir ledit substrat (110) ;
fabriquer une couche épitaxiale le long d'une surface de croissance du substrat (110), dans lequel la couche épitaxiale comprend ladite première couche de nitrure de type P (130) et ladite deuxième couche de nitrure de type P, la deuxième couche de nitrure de type P est située de part et d'autre de la première couche de nitrure de type P (130), la première couche de nitrure de type P (130) et la deuxième couche de nitrure de type P sont formées par croissance épitaxiale synchrone, et la concentration de dopage de la deuxième couche de nitrure de type P est variable dans la direction de croissance épitaxiale ;
modifier la deuxième couche de nitrure de type P de manière à former ladite couche modifiée (140) de part et d'autre de la première couche de nitrure de type P
fabriquer ladite couche de canal (150) ;
fabriquer ladite couche barrière (160) ; et
fabriquer ladite électrode de grille, ladite électrode de source et ladite électrode de drain ;
dans lequel l'étape consistant à modifier la deuxième couche de nitrure de type P de manière à former une couche modifiée (140) de part et d'autre de la première couche de nitrure de type P (130) comprend les étapes consistant à :
fabriquer un masque le long d'une surface de la première couche de nitrure de type P (130) ;
modifier partiellement la deuxième couche de nitrure de type P par implantation ionique ;
modifier la deuxième couche de nitrure de type P située dans une région d'électrode de drain par implantation ionique, jusqu'à ce que la deuxième couche de nitrure de type P située dans la région d'électrode de drain soit entièrement modifiée ; et
retirer le masque, et
après l'étape de fabrication de ladite électrode de grille, de ladite électrode de source et de ladite électrode de drain, le procédé comprend en outre :
la fabrication de ladite électrode de corps (180), dans laquelle l'électrode de corps (180) est connectée respectivement à la deuxième couche de nitrure de type P et à l'électrode de source.

8. Procédé de fabrication d'un dispositif normalement fermé (100) selon la revendication 7, dans lequel l'étape consistant à modifier la deuxième couche de nitrure de type P par implantation ionique comprend :
l'implantation de Si, Ge, N ou Ar dans la deuxième couche de nitrure de type P par implantation ionique.

9. Procédé de fabrication d'un dispositif normalement fermé (100) selon la revendication 7, dans lequel l'étape consistant à modifier partiellement la deuxième couche de nitrure de type P par implantation ionique comprend les étapes consistant à :
implanter des ions dans la deuxième couche de nitrure de type P selon une première énergie et une première dose, et
modifier la deuxième couche de nitrure de type P située dans une région d'électrode de drain par implantation ionique jusqu'à ce que la deuxième couche de nitrure de type P située dans la région d'électrode de drain soit complètement modifiée, cette étape comprenant :
l'implantation d'ions dans la deuxième couche de nitrure de type P selon une deuxième énergie et une deuxième dose, la première énergie et la première dose étant inférieures à la deuxième énergie et à la deuxième dose.
